# FASCICULE DE BREVET EUROPEEN

(11) **EP 3 172 394 B1**
(45) Date de publication et mention de la délivrance du brevet: **15.01.2020**
(21) Numéro de dépôt: 15741549.8
(22) Date de dépôt: 23.07.2015
(51) Int. Cl.: E06B 9/15, E06B 9/68, G01R 19/00

(54) **PROCÉDÉ DE COMMANDE EN FONCTIONNEMENT D'UN DISPOSITIF D'ENTRAÎNEMENT MOTORISÉ D'UNE INSTALLATION DOMOTIQUE DE FERMETURE OU DE PROTECTION SOLAIRE ET DISPOSITIF ASSOCIÉ**
VERFAHREN ZUR STEUERUNG EINES ROLLLADENANTRIEBS, ANTRIEBSSYSTEM MIT DIESEM VERFAHREN UND SONNENSCHUTZSYSTEM MIT DIESEM ANTRIEB.
METHOD OF CONTROLLING A BLIND DRIVE, DRIVE SYSTEM WITH SUCH METHOD AND BLIND WITH SUCH DRIVE

(30) Priorité: 25.07.2014 FR 1457199
(43) Date de publication de la demande: 31.05.2017
(73) Titulaire: SOMFY ACTIVITES SA, 74300 Cluses (FR)
(72) Inventeur: MUGNIER, David, 74130 Mont-Saxonnex (FR)
(74) Mandataire: Lavoix
(86) Numéro de dépôt international: PCT/EP2015/066938
(87) Numéro de publication internationale: WO 2016/012566

(56) Documents cités:
- EP-A1- 2 725 182
- JP-A- 2005 042 485

## Description

La présente invention concerne un procédé de commande en fonctionnement d'un dispositif d'entraînement motorisé d'une installation domotique, de fermeture ou de protection solaire.

La présente invention concerne également un dispositif d'entraînement motorisé d'une installation domotique de fermeture ou de protection solaire adapté à mettre en œuvre ce procédé de commande.

De manière générale, la présente invention concerne le domaine des dispositifs d'occultation comprenant un dispositif d'entraînement motorisé mettant en mouvement un écran entre au moins une première position et une deuxième position.

Un dispositif d'entraînement motorisé comprend un actionneur électromécanique d'un élément mobile de fermeture, d'occultation ou de protection solaire, tel qu'un volet, une porte, une grille, un store, ou tout autre matériel équivalent, appelé par la suite écran.

On connaît déjà le document JP 2005 042 485 A qui décrit un dispositif d'entraînement motorisé d'une installation domotique de fermeture ou de protection solaire. L'installation domotique de fermeture ou de protection solaire comprend un dispositif d'occultation. Le dispositif d'occultation comprend un écran, en particulier un volet roulant, et un tube d'enroulement. Le dispositif d'entraînement motorisé comprend un actionneur électromécanique permettant d'enrouler et de dérouler l'écran sur le tube d'enroulement, entre une position enroulée et une position déroulée. L'actionneur électromécanique comprend un moteur électrique à courant continu. Le moteur électrique à courant continu comprend un arbre de sortie relié au tube d'enroulement du dispositif d'occultation. Le moteur électrique à courant continu comprend également une unité électronique de contrôle. L'unité électronique de contrôle comprend un dispositif de mesure d'un paramètre physique, en particulier d'une valeur d'intensité du courant électrique traversant le moteur électrique à courant continu, une mémoire stockant une pluralité de valeurs seuils d'intensité et un dispositif de détection d'obstacle lors de l'enroulement de l'écran ou lors du déroulement de l'écran.

La course de déplacement de l'écran comporte plusieurs portions lors de l'enroulement de l'écran ou lors du déroulement de l'écran. Et chaque portion de la course de déplacement de l'écran est associée à une valeur seuil d'intensité, de sorte à adapter la sensibilité de détection d'obstacle à chaque portion de la course de déplacement de l'écran. L'unité électronique de contrôle mesure différentes valeurs d'intensité traversant le moteur électrique à courant continu au travers du dispositif de mesure lors du déplacement de l'écran par le dispositif d'entraînement motorisé.

Suite à l'échantillonnage des valeurs d'intensité mesurées, celles-ci sont converties par un convertisseur analogique/numérique, puis stockées dans une mémoire de l'unité électronique de contrôle, de sorte à constituer un profil. Les valeurs d'intensité mesurées sont représentatives du couple fourni par le moteur électrique à courant continu de l'actionneur électromécanique.

L'unité électronique de contrôle comprend des moyens de mise à jour des valeurs seuils d'intensité obtenues par l'ajout d'une marge à une valeur d'intensité de référence, la valeur d'intensité de référence correspondant à une valeur d'intensité mesurée récemment par le dispositif de mesure, de sorte à prendre en considération les changements de saison et le vieillissement de l'installation domotique. La valeur d'intensité de référence correspond à la valeur d'intensité mesurée ayant la valeur la plus élevée parmi les dernières valeurs d'intensité mesurées, ou à une valeur d'intensité plus grande que la valeur la plus élevée parmi les dernières valeurs d'intensité mesurées, ou à une valeur d'intensité intermédiaire parmi les dernières valeurs d'intensité mesurées, ou encore à une valeur d'intensité correspondant à la moyenne des dernières valeurs d'intensité mesurées. La marge ajoutée à la valeur d'intensité de référence permettant de définir une valeur seuil d'intensité peut être différente suivant le sens de déplacement de l'écran du dispositif d'occultation, en particulier, lors de l'enroulement de l'écran ou lors du déroulement de l'écran.

L'unité électronique de contrôle compare les valeurs d'intensité mesurées par rapport à l'une des valeurs seuils d'intensité mises à jour et détermine la présence ou l'absence d'un obstacle.

Cependant, ce dispositif d'entraînement motorisé présente l'inconvénient de détecter les butées de fins de course haute et basse lors du déplacement de l'écran du dispositif d'occultation au moyen d'interrupteurs additionnels par rapport au dispositif de détection d'obstacle mis en œuvre de manière logicielle permettant de détecter un obstacle entre les butées de fins de course haute et basse par le dispositif de mesure de courant traversant le moteur électrique à courant continu. Par conséquent, un tel dispositif d'entraînement motorisé comportant, d'une part, un dispositif de détection de butées de fins de course et, d'autre part, un dispositif de détection d'obstacles engendre des coûts d'obtention onéreux.

En outre, ce dispositif d'entraînement motorisé comprenant un dispositif de détection d'obstacle, où les valeurs seuils d'intensité sont déterminées par l'ajout d'une marge en fonction des valeurs d'intensité mesurées précédemment, engendre des difficultés pour garantir la mise à jour des valeurs seuils d'intensité en fonction de la fréquence d'utilisation du dispositif d'entraînement motorisé, des variations de fonctionnement liées aux conditions climatiques de l'environnement de l'installation domotique. Par ailleurs, ce dispositif d'entraînement motorisé nécessite une phase d'apprentissage, lors de la mise en service de l'installation domotique, pour déterminer un profil d'évolution de l'intensité traversant le moteur électrique lors du déroulement de l'écran et lors l'enroulement de l'écran. Par conséquent, le dispositif de détection d'obstacle peut engendrer des arrêts intempestifs du dispositif d'entraînement motorisé dans le cas où les valeurs seuils d'intensité sont trop faibles, ou omettre de détecter des obstacles dans le cas où les valeurs seuils d'intensité sont trop élevées.

La présente invention a pour but de résoudre les inconvénients précités et de proposer un procédé de commande en fonctionnement d'un dispositif d'entraînement motorisé d'une installation domotique de fermeture ou de protection solaire, ainsi qu'un dispositif d'entraînement motorisé associé, permettant de déterminer les fins de course de déplacement de l'écran, ainsi que la présence ou l'absence d'obstacle, au moyen d'un même dispositif de détection mis en œuvre de manière logicielle, tout en minimisant les coûts d'obtention du dispositif d'entraînement motorisé.

A cet effet, la présente invention vise, selon un premier aspect, un procédé de commande en fonctionnement d'un dispositif d'entraînement motorisé d'une installation domotique de fermeture ou de protection solaire,
l'installation domotique de fermeture ou de protection solaire comprenant un dispositif d'occultation,
le dispositif d'occultation comprenant au moins :
- un écran, et
- un tube d'enroulement,
le dispositif d'entraînement motorisé comprenant au moins :
- un actionneur électromécanique permettant d'enrouler et de dérouler l'écran sur le tube d'enroulement, entre une position enroulée et une position déroulée,
l'actionneur électromécanique comprenant au moins :
- un moteur électrique, le moteur électrique comprenant un arbre de sortie relié au tube d'enroulement du dispositif d'occultation, et
- une unité électronique de contrôle,
l'unité électronique de contrôle comprenant au moins :
- un dispositif de mesure d'une valeur d'intensité d'un courant électrique traversant le moteur électrique,
- une mémoire stockant une pluralité de valeurs seuils d'intensité, et
- un dispositif de détection d'obstacle et de fins de course lors de l'enroulement de l'écran et lors du déroulement de l'écran,
ledit procédé comprend au moins :
- une étape de mesure d'une première valeur d'intensité du courant électrique traversant le moteur électrique par le dispositif de mesure.
Selon l'invention, ledit procédé comprend au moins :
- une étape de détermination d'un écart d'intensité par rapport à la première valeur d'intensité mesurée, suite à l'écoulement d'une période de temps démarrant à partir de l'instant de mesure de la première valeur d'intensité,
- une étape de sélection de l'une des valeurs seuils d'intensité en fonction de la période de temps écoulée,
- une étape de comparaison de l'écart d'intensité déterminé par rapport à la valeur seuil d'intensité sélectionnée, et
- une étape de détermination de présence ou d'absence d'un obstacle ou d'une fin de course par le dispositif de détection en fonction du résultat de l'étape de comparaison.

Ainsi, le procédé de commande permet de déterminer l'atteinte ou non des fins de course de déplacement de l'écran, ainsi que la présence ou l'absence d'obstacle par la surveillance d'écarts d'intensité par rapport à une première valeur d'intensité traversant le moteur électrique.

De cette manière, le procédé de commande permet de déterminer la présence ou l'absence d'un obstacle ou d'une fin de course de manière dynamique, en comparant des écarts d'intensité déterminés à partir d'une première valeur d'intensité traversant le moteur électrique par rapport à une valeur seuil d'intensité sélectionnée en fonction de la période de temps écoulée entre l'instant de mesure de la première valeur d'intensité et l'instant de détermination d'un écart d'intensité.

Par conséquent, le procédé de commande permet de garantir la protection du dispositif d'entraînement motorisé ainsi que de l'installation domotique, tout en limitant les arrêts intempestifs de déplacement de l'écran du dispositif d'occultation.

La mise en œuvre d'un tel procédé de commande dans lequel la détermination de présence ou d'absence d'un obstacle ou d'une fin de course de manière logicielle par le dispositif de détection permet de minimiser les coûts d'obtention du dispositif d'entraînement motorisé.

Par ailleurs, le procédé de commande en fonctionnement du dispositif d'entraînement motorisé permet de s'affranchir d'une phase d'apprentissage lors de la mise en service de l'installation domotique ayant pour but de déterminer un profil d'évolution de l'intensité du courant électrique traversant le moteur électrique lors du déroulement de l'écran et lors l'enroulement de l'écran.

Selon une caractéristique préférée de l'invention, ce procédé comprend une ou plusieurs étapes additionnelles de mesure d'une autre valeur d'intensité traversant le moteur électrique par le dispositif de mesure, suite à la mise en œuvre de l'étape de mesure de la première valeur d'intensité traversant le moteur électrique ; une étape de détermination d'une évolution de la valeur d'intensité traversant le moteur électrique au travers des étapes de mesure d'une valeur d'intensité traversant le moteur électrique. Le procédé met en œuvre l'étape de détermination d'un écart d'intensité par rapport à la première valeur d'intensité mesurée lorsque l'étape de détermination d'une évolution de la valeur d'intensité traversant le moteur électrique détermine une augmentation de la valeur d'intensité traversant le moteur électrique.

Pratiquement, dans le cas où une diminution de la valeur d'intensité traversant le moteur électrique est déterminée, lors de l'étape de détermination d'une évolution de la valeur d'intensité traversant le moteur électrique, le procédé de commande met en œuvre de nouveau l'étape de mesure de la première valeur d'intensité traversant le moteur électrique.

Selon une autre caractéristique préférée de l'invention, suite à l'étape de détermination d'un écart d'intensité par rapport à la première valeur d'intensité mesurée, le procédé comprend une étape de détermination d'une évolution de l'écart d'intensité par rapport à la première valeur d'intensité mesurée.

Pratiquement, l'étape de détermination d'un écart d'intensité par rapport à la première valeur d'intensité mesurée est mise en œuvre périodiquement, tant que le résultat de l'étape de détermination d'une évolution de l'écart d'intensité correspond à une augmentation de la valeur d'intensité traversant le moteur électrique.

Avantageusement, l'étape de détermination d'un écart d'intensité par rapport à la première valeur d'intensité mesurée est mise en œuvre périodiquement, tant que le résultat de l'étape de détermination de présence ou d'absence d'un obstacle ou d'une fin de course est différent d'un obstacle ou d'une fin de course détecté.

Préférentiellement, l'étape de détermination d'un écart d'intensité par rapport à la première valeur d'intensité mesurée est mise en œuvre périodiquement pendant une période de temps prédéterminée démarrant à partir de l'instant de mesure de la première valeur d'intensité.

Pratiquement, l'étape de mesure de la première valeur d'intensité traversant le moteur électrique est mise en œuvre suite à l'écoulement d'une période de temps prédéterminée démarrant à partir de l'instant de commande de démarrage du moteur électrique.

Selon une autre caractéristique préférée de l'invention, le procédé comprend également une étape de détermination du sens de rotation de l'arbre de sortie du moteur électrique, une étape de détermination de la position de l'écran du dispositif d'occultation et une étape de détermination de plusieurs portions de la course de déplacement de l'écran lors de l'enroulement de l'écran et lors du déroulement de l'écran. Au moins les étapes de détermination d'un écart d'intensité, de sélection de l'une des valeurs seuils d'intensité, de comparaison de l'écart d'intensité déterminé par rapport à la valeur seuil d'intensité sélectionnée et de détermination de présence ou d'absence d'un obstacle ou d'une fin de course sont mises en œuvre au cours d'au moins une portion de la course de déplacement de l'écran, lors de l'enroulement de l'écran ou lors du déroulement de l'écran.

Pratiquement, au moins lesdites étapes de détermination d'un écart d'intensité, de sélection de l'une des valeurs seuils d'intensité, de comparaison de l'écart d'intensité déterminé par rapport à la valeur seuil d'intensité sélectionnée et de détermination de présence ou d'absence d'un obstacle ou d'une fin de course sont mises en œuvre au cours d'une portion de démarrage de la course de déplacement de l'écran, lors de l'enroulement de l'écran ou lors du déroulement de l'écran, suite à l'atteinte d'une fin de course.

La présente invention vise, selon un deuxième aspect, un dispositif d'entraînement motorisé d'une installation domotique de fermeture ou de protection solaire comprenant une unité électronique de contrôle configurée pour mettre en œuvre le procédé de commande selon l'invention.

Ce dispositif d'entraînement motorisé présente des caractéristiques et avantages analogues à ceux décrits précédemment en relation avec le procédé de commande selon l'invention.

Préférentiellement, le moteur électrique de l'actionneur électromécanique est de type sans balais à commutation électronique.

D'autres particularités et avantages de l'invention apparaîtront encore dans la description ci-après.

Aux dessins annexés, donnés à titre d'exemples non limitatifs :
- la figure 1 est une vue schématique en coupe d'une installation domotique conforme à un mode de réalisation de l'invention ;
- la figure 2 est une vue schématique en perspective de l'installation domotique illustrée à la figure 1 ;
- la figure 3 est une coupe schématique partielle de l'installation domotique illustrée aux figures 1 et 2, montrant un actionneur électromécanique ;
- la figure 4 est un schéma électrique de l'actionneur électromécanique, tel qu'illustré à la figure 3, comprenant un moteur électrique et une unité électronique de contrôle ;
- la figure 5 est un schéma bloc d'un algorithme d'un procédé de commande d'un dispositif d'entraînement motorisé de l'installation domotique, telle qu'illustrée aux figures 1 à 4, conforme à un mode de réalisation de l'invention ;
- la figure 6 est un graphique représentant l'échantillonnage de valeurs d'intensité d'un courant électrique traversant un moteur électrique au cours d'étapes de mesures lorsque le procédé de commande, tel que représenté à la figure 5, est mis en oeuvre ; et
- la figure 7 est un graphique représentant l'évolution des valeurs seuils d'intensité en fonction du temps lors d'une recherche de détection d'obstacle ou de fin de course lorsque le procédé de commande, tel que représenté à la figure 5, est mis en œuvre.

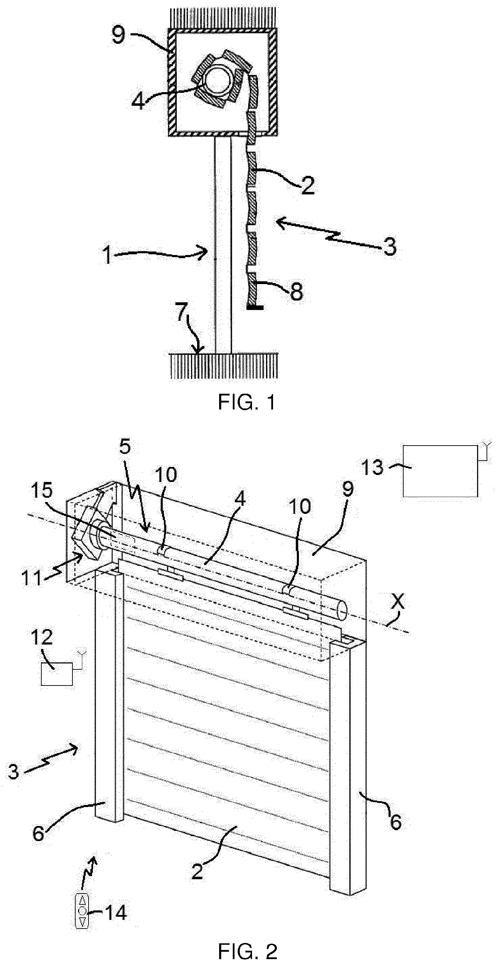

On va décrire tout d'abord, en référence aux figures 1 et 2, une installation domotique conforme à l'invention et installée dans un bâtiment comportant une ouverture 1, fenêtre ou porte, équipée d'un écran 2 appartenant à un dispositif d'occultation 3, en particulier un volet roulant motorisé.

Le dispositif d'occultation 3 peut être un volet roulant, un store en toile ou avec des lames orientables, ou encore un portail roulant. En pratique, la présente invention s'applique à tous les types de dispositif d'occultation.

On va décrire, en référence aux figures 1 et 2, un volet roulant conforme à un mode de réalisation de l'invention.

L'écran 2 du dispositif d'occultation 3 est enroulé sur un tube d'enroulement 4 entraîné par un dispositif d'entraînement motorisé 5 et mobile entre une position enroulée, en particulier haute, et une position déroulée, en particulier basse.

Le dispositif d'entraînement motorisé 5 comprend un actionneur électromécanique 11, en particulier de type tubulaire, permettant de mettre en rotation le tube d'enroulement 4 de sorte à dérouler ou enrouler l'écran 2 du dispositif d'occultation 3.

Le dispositif d'occultation 3 comprend le tube d'enroulement 4 pour enrouler l'écran 2, où, dans l'état monté, l'actionneur électromécanique 11 est inséré dans le tube d'enroulement 4.

L'écran 2 mobile du dispositif d'occultation 3 est un écran de fermeture, d'occultation et/ou de protection solaire, s'enroulant sur le tube d'enroulement 4 dont le diamètre intérieur est sensiblement équivalent au diamètre externe actionneur électromécanique 11, de sorte que l'actionneur électromécanique 11 puisse être inséré dans le tube d'enroulement 4 lors de l'assemblage du dispositif d'occultation 3.

De manière connue, un volet roulant 3 comporte un tablier comprenant des lames horizontales articulées les unes aux autres, formant l'écran 2 du volet roulant 3, et guidées par deux glissières latérales 6. Ces lames sont jointives lorsque le tablier 2 du volet roulant 3 atteint sa position basse déroulée.

Dans le cas d'un volet roulant, la position haute enroulée correspond à la mise en appui d'une lame d'extrémité finale 8 en forme de L du tablier 2 du volet roulant 3 contre un bord d'un coffre 9 du volet roulant 3, et la position basse déroulée correspond à la mise en appui de la lame d'extrémité finale 8 du tablier 2 du volet roulant 3 contre un seuil 7 de l'ouverture 1.

La première lame du volet roulant 3, opposée à la lame d'extrémité, est reliée au tube d'enroulement 4 au moyen d'au moins une articulation 10.

Le tube d'enroulement 4 est disposé à l'intérieur du coffre 9 du volet roulant 3. Le tablier 2 du volet roulant 3 s'enroule et se déroule autour du tube d'enroulement 4 et est logé au moins en partie à l'intérieur du coffre 9.

Le dispositif d'entraînement motorisé 5 est commandé par une unité de commande. L'unité de commande peut être, par exemple, une unité de commande locale 12, où l'unité de commande locale 12 peut être reliée en liaison filaire ou non filaire avec une unité de commande centrale 13. L'unité de commande centrale 13 pilote l'unité de commande locale 12, ainsi que d'autres unités de commande locales similaires et réparties dans le bâtiment.

L'unité de commande centrale 13 peut être en communication avec une station météorologique déportée à l'extérieur du bâtiment, incluant notamment un ou plusieurs capteurs pouvant être configurés pour déterminer, par exemple, une température, une luminosité, ou encore une vitesse de vent.

Une télécommande 14, pouvant être un type d'unité de commande locale, et pourvue d'un clavier de commande, qui comprend des moyens de sélection et d'affichage, permet, en outre, à un utilisateur d'intervenir sur l'actionneur électromécanique 11 et/ou l'unité de commande centrale 13.

Le dispositif d'entraînement motorisé 5 est, de préférence, configuré pour exécuter les commandes de déroulement ou d'enroulement de l'écran 2 du dispositif d'occultation 3, pouvant être émises notamment par la télécommande 14.

L'actionneur électromécanique 11 comprend un moteur électrique 16. Le moteur électrique 16 comprend un rotor et un stator positionnés de manière coaxiale autour d'un axe de rotation X.

Des moyens de commande de l'actionneur électromécanique 11, permettant le déplacement de l'écran 2 du dispositif d'occultation 3, sont constitués par au moins une unité électronique de contrôle 15. Cette unité électronique de contrôle 15 est apte à mettre en fonctionnement le moteur électrique 16 de l'actionneur électromécanique 11, et en particulier permettre l'alimentation en énergie électrique du moteur électrique 16. Ainsi, l'unité électronique de contrôle 15 commande, notamment le moteur électrique 16, de sorte à ouvrir ou fermer l'écran 2, comme décrit précédemment.

L'unité électronique de contrôle 15 comprend également un module de réception d'ordres, en particulier d'ordres radioélectriques émis par un émetteur d'ordres, tel que la télécommande 14 destinée à commander l'actionneur électromécanique 11. Le module de réception d'ordres peut également permettre la réception d'ordres transmis par des moyens filaires.

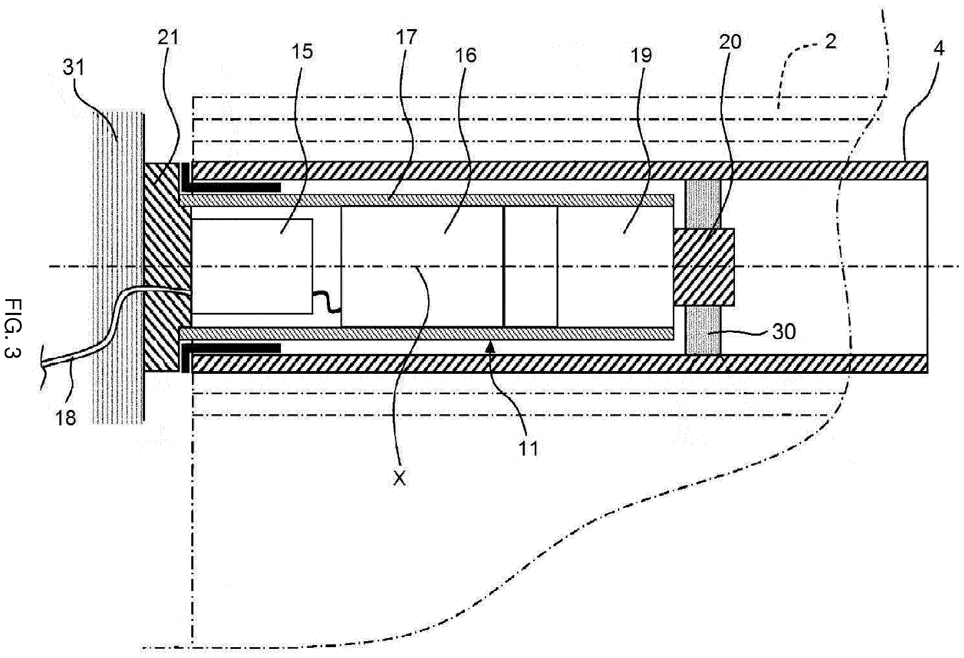

Ici, et tel qu'illustré à la figure 3, l'unité électronique de contrôle 15 est disposée à l'intérieur d'un carter 17 de l'actionneur électromécanique 11.

Les moyens de commande de l'actionneur électromécanique 11 comprennent des moyens matériels et/ou logiciels. A titre d'exemple nullement limitatif, les moyens matériels peuvent comprendre au moins un microcontrôleur.

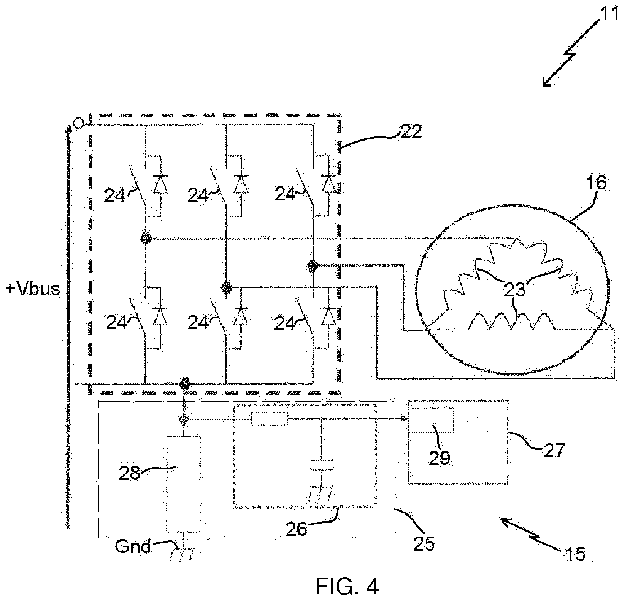

On va décrire à présent, plus en détail et en référence aux figures 3 et 4, l'actionneur électromécanique 11 appartenant à l'installation domotique des figures 1 et 2.

L'actionneur électromécanique 11 est alimenté en énergie électrique par un réseau d'alimentation électrique du secteur, ou encore au moyen d'une batterie, pouvant être rechargée, par exemple, par un panneau photovoltaïque. L'actionneur électromécanique 11 permet de déplacer l'écran 2 du dispositif d'occultation 3.

Ici, l'actionneur électromécanique 11 comprend un câble d'alimentation électrique 18 permettant son alimentation en énergie électrique depuis le réseau d'alimentation électrique du secteur.

Dans un autre mode de réalisation non représenté, l'actionneur électromécanique 11 est destiné à être placé dans un rail profilé en U.

Le carter 17 de l'actionneur électromécanique 11 est, préférentiellement, de forme cylindrique. Dans un mode de réalisation, le carter 17 peut être réalisé dans un matériau métallique. La matière du carter de l'actionneur électromécanique n'est nullement limitative et peut être différente, et en particulier en matière plastique.

Ici, le moteur électrique 16 est de type sans balais à commutation électronique, ou appelé « BLDC » (acronyme du terme anglo-saxon BrushLess Direct Current), ou encore appelé synchrone à aimants permanents.

Le rotor du moteur électrique 16 comprend un corps de rotor muni d'éléments magnétiques entourés par le stator. Ici, les éléments magnétiques sont des aimants permanents.

Le stator du moteur électrique 16 est formé par un noyau de stator comprenant des éléments polaires répartis sur la périphérie du stator. Les éléments polaires sont également appelés des dents.

Le stator du moteur électrique 16 comprend des bobinages 23, en l'occurrence trois, reliés électriquement entre eux, tel qu'illustré à la figure 4.

Préférentiellement, les bobinages 23 sont positionnés autour des éléments polaires du stator. Plus précisément, chaque élément polaire est entouré par un bobinage 23 qui lui est propre. Les bobinages 23 sont reliés entre eux de sorte que lorsqu'ils sont parcourus par un courant, ils produisent un champ électromagnétique tournant qui entraîne en rotation le rotor.

L'actionneur électromécanique 11 comprend également un dispositif de réduction à engrenages 19 et un arbre de sortie 20. Avantageusement, le moteur électrique 16 et le dispositif de réduction à engrenages 19 sont disposés à l'intérieur du carter 17 de l'actionneur électromécanique 11.

L'arbre de sortie 20 de l'actionneur électromécanique 11 est disposé à l'intérieur du tube d'enroulement 4, et au moins en partie à l'extérieur du carter 17 de l'actionneur électromécanique 11.

L'arbre de sortie 20 de l'actionneur électromécanique 11 est accouplé par un moyen de liaison 30 au tube d'enroulement 4, en particulier un moyen de liaison en forme de roue.

L'actionneur électromécanique 11 comprend également un élément d'obturation 21 d'une extrémité du carter 17.

Ici, le carter 17 de l'actionneur électromécanique 11 est fixé à un support 31, en particulier une joue, du coffre 9 du dispositif d'occultation 3 au moyen de l'élément d'obturation 21 formant un support de couple, en particulier une tête d'obturation et de reprise de couple. Dans un tel cas où l'élément d'obturation 21 forme un support de couple, l'élément d'obturation 21 est également appelé un point fixe de l'actionneur électromécanique 11.

L'unité électronique de contrôle 15 de l'actionneur électromécanique 11 comprend un circuit non représenté de redressement de la tension alternative du réseau d'alimentation électrique et un module d'alimentation électrique 22. Le module d'alimentation électrique 22 est ainsi connecté électriquement à une source de tension continue +Vbus. La valeur de la tension continue +Vbus est définie par rapport à une tension de référence Gnd.

Le module d'alimentation électrique 22 alimente en énergie électrique, de manière séquentielle, les bobines 23, de sorte à produire le champ électromagnétique tournant provoquant l'entraînement en rotation du rotor du moteur électrique 16.

Le module d'alimentation électrique 22 comprend des commutateurs 24 permettant de réaliser l'alimentation électrique séquentielle des bobines 23.

Ici, les commutateurs 24 du module d'alimentation électrique 22 sont des transistors de type « MOSFET » (acronyme du terme anglo-saxon Metal Oxide Semiconductor Field Effect Transistor), et au nombre de six. Le type de commutateurs du module d'alimentation électrique et leur nombre ne sont nullement limitatifs. En particulier, les commutateurs 24 du module d'alimentation électrique 22 peuvent être des transistors de type « IGBT » (acronyme du terme anglo-saxon Insulated Gate Bipolar Transistor).

L'unité électronique de contrôle 15 de l'actionneur électromécanique 11 comprend un dispositif de mesure 28 d'une valeur d'intensité I d'un courant électrique traversant le moteur électrique 16. Au sens de la présente invention, l'intensité traversant le moteur électrique 16 est l'intensité d'un courant électrique traversant ce moteur électrique 16 en fonctionnement. L'intensité traversant le moteur électrique 16 est obtenue au moyen d'un signal redressé positif prenant en considération le courant de chacune des bobines 23 du moteur électrique 16.

L'acquisition de la valeur d'intensité I traversant le moteur électrique 16 par l'intermédiaire du dispositif de mesure 28 permet d'obtenir un signal représentatif du couple généré par le moteur électrique 16 de l'actionneur électromécanique 11.

Ici, le dispositif de mesure 28 de la valeur d'intensité I est mis en œuvre au moyen d'une résistance, dite de « shunt », connectée électriquement au module d'alimentation électrique 22 et à la tension de référence Gnd.

Le dispositif de mesure 28 fait partie intégrante d'un générateur de signaux 25. Ce générateur de signaux 25 comprend également un filtre analogique 26, en particulier d'un circuit RC passe-bas, le circuit RC étant constitué d'une résistance et d'une capacité.

Le générateur de signaux 25 permet de délivrer un signal représentatif de l'alimentation électrique fournie au moteur électrique 16, en particulier de l'intensité I traversant le moteur électrique 16, à une entrée d'un microcontrôleur 27. L'entrée du microcontrôleur 27 comprend un convertisseur analogique/numérique 29.

Le signal de la valeur d'intensité I acquis par le dispositif de mesure 28 est également traité numériquement par au moins un filtre numérique, pouvant être par exemple un filtre passe-bas, mis en œuvre par le microcontrôleur 27.

L'unité électronique de contrôle 15 de l'actionneur électromécanique 11 comprend une mémoire stockant une pluralité de valeurs seuils d'intensité S. Ici, la mémoire stockant une pluralité de valeurs seuils d'intensité S est réalisée par une mémoire du microcontrôleur 27, en particulier une mémoire de type « EEPROM » (acronyme du terme anglo-saxon Electrically Erasable Programmable Read Only Memory).

L'unité électronique de contrôle 15 de l'actionneur électromécanique 11 comprend un dispositif de détection d'obstacle et de fins de course lors de l'enroulement de l'écran 2 et lors du déroulement de cet écran.

Le dispositif de détection d'obstacle et de fins de course lors de l'enroulement et lors du déroulement de l'écran 2 est mis en œuvre au moyen du microcontrôleur 27, et en particulier au moyen d'un algorithme mis en œuvre par ce microcontrôleur.

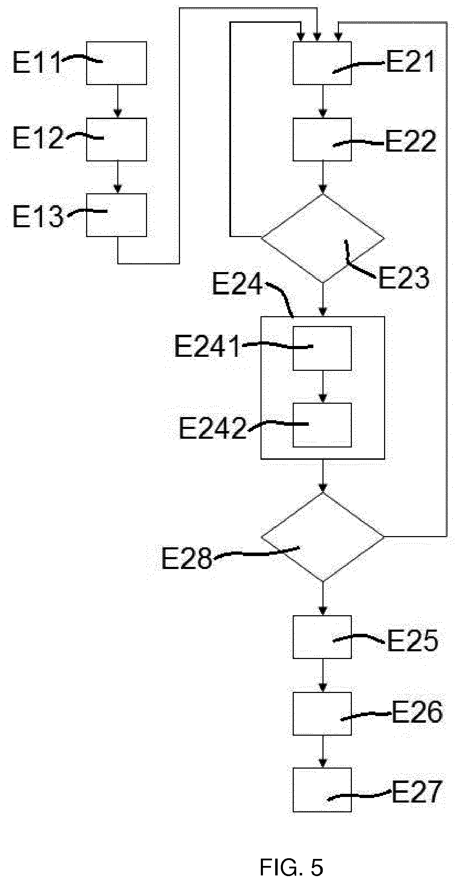

On va décrire à présent, en référence aux figures 5 à 7, un procédé de commande en fonctionnement du dispositif d'entraînement motorisé 5 de l'installation domotique conforme à l'invention représentée aux figures 1 à 4.

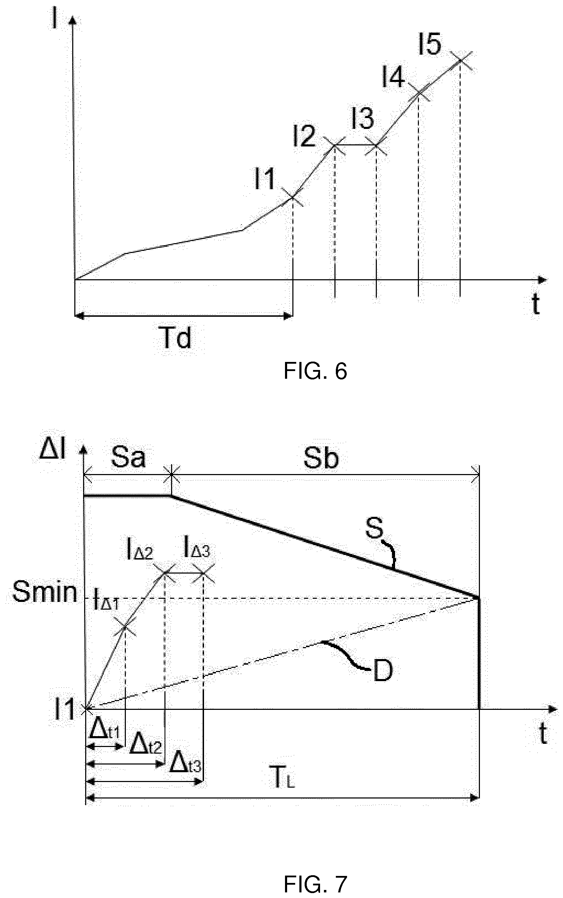

A la figure 6, le graphique illustre, par une courbe en trait plein, l'évolution de la valeur d'intensité I traversant le moteur électrique 16, en fonction du temps t.

Le temps t est représenté sur l'axe des abscisses, la valeur d'intensité I est représentée sur l'axe des ordonnées.

A la figure 7, le graphique illustre, par une courbe en trait plein épais, l'évolution des valeurs seuils d'intensité S en fonction du temps t et, par une autre courbe en trait plein fin, l'évolution de l'écart d'intensité ΔI par rapport à une première valeur d'intensité I1 mesurée.

Le temps t est représenté sur l'axe des abscisses, les valeurs seuils d'intensité S et l'écart d'intensité ΔI sont représentés sur l'axe des ordonnées.

Le procédé de commande comprend une étape de mesure E21 d'une première valeur d'intensité I1 du courant électrique traversant le moteur électrique 16 par le dispositif de mesure 28, tel qu'illustré à la figure 6.

Préférentiellement, l'étape de mesure E21 de la première valeur d'intensité I1 est mise en œuvre, suite à l'écoulement d'une période de temps prédéterminée Td démarrant à partir de l'instant de commande de démarrage du moteur électrique 16. De cette manière, l'étape de mesure E21 de la première valeur d'intensité I1 traversant le moteur électrique 16 est mise en œuvre après la période transitoire de démarrage du moteur électrique 16 au cours de laquelle des fluctuations de la valeur d'intensité I peuvent être générées. Ainsi, la première valeur d'intensité I1 mesurée, lors de l'étape de mesure E21, est fiable pour débuter la détermination de présence ou d'absence d'un obstacle ou d'une fin de course lors de l'enroulement de l'écran 2 ou lors du déroulement de l'écran 2.

A titre d'exemple nullement limitatif, la période de temps prédéterminée Td, démarrant à partir de l'instant de commande de démarrage du moteur électrique 16, est de l'ordre de 300 millisecondes.

Dans un mode de réalisation, la commande de démarrage du moteur électrique 16 correspond à la commutation des commutateurs 24 de pilotage du moteur électrique 16.

Puis, le procédé de commande comprend une ou plusieurs étapes additionnelles de mesure E22 d'une autre valeur d'intensité I2, I3, I4, I5 traversant le moteur électrique 16 par le dispositif de mesure 28, suite à la mise en œuvre de l'étape de mesure E21, tel qu'illustré à la figure 6.

Ici et de manière nullement limitative, le procédé de commande comprend quatre étapes additionnelles de mesure E22 de quatre autre valeurs d'intensité I2, I3, I4, I5 traversant le moteur électrique 16 par le dispositif de mesure 28 suite à la mise en œuvre de l'étape de mesure E21.

Avantageusement, les étapes additionnelles de mesure E22 d'une autre valeur d'intensité I2, I3, I4, I5 sont mises en œuvre périodiquement suite à la mise en œuvre de l'étape de mesure E21. A titre d'exemple nullement limitatif, les étapes additionnelles de mesure E22 sont mises en œuvre successivement avec une périodicité de l'ordre de 5 millisecondes.

Préférentiellement, le nombre d'étapes additionnelles de mesure E22 d'une autre valeur d'intensité I2, I3, I4, I5 par le dispositif de mesure 28 est dépendant de la vitesse de rotation de l'arbre de sortie 20 de l'actionneur électromécanique 11.

Ainsi, l'adaptation du nombre d'étapes additionnelles de mesure E22 en fonction de la vitesse de rotation de l'arbre de sortie 20 de l'actionneur électromécanique 11 permet de mettre en œuvre l'acquisition des valeurs d'intensité I1, I2, I3, I4, I5 selon une même périodicité.

A titre d'exemple nullement limitatif, le nombre d'étapes additionnelles de mesure E22 est de quatre pour une vitesse de rotation de 17 tours par minute de l'arbre de sortie 20 de l'actionneur électromécanique 11, et de neuf pour une vitesse de rotation de 8 tours par minute de l'arbre de sortie 20 de l'actionneur électromécanique 11.

Pratiquement, le nombre d'étapes additionnelles de mesure E22 d'une autre valeur d'intensité I2, I3, I4, I5 suit une loi linéaire en fonction de la vitesse de rotation de l'arbre de sortie 20 de l'actionneur électromécanique 11.

Le procédé de commande comprend, ensuite, une étape de détermination E23 d'une évolution de la valeur d'intensité I traversant le moteur électrique 16 au travers des étapes de mesure E21, E22 des valeurs d'intensité I1, I2, I3, I4, I5.

Ici, l'étape de détermination E23 est mise en œuvre au moyen de l'unité électronique de contrôle 15, et en particulier du microcontrôleur 27 de l'unité électronique de contrôle 15.

Le procédé de commande comprend également une étape de détermination E24 d'un écart d'intensité ΔI par rapport à la première valeur d'intensité I1 mesurée, suite à l'écoulement d'une période de temps Δt démarrant à partir de la première valeur d'intensité I1 mesurée, tel qu'illustré à la figure 7.

La période de temps Δt s'étend entre l'instant de mesure de la première valeur d'intensité I1 et l'instant de détermination de l'écart d'intensité ΔI par rapport à la première valeur d'intensité I1 mesurée.

Dans un mode de réalisation, la période de temps Δt correspond à une longueur de course de déplacement de l'écran 2, ou autrement dit à une position atteinte par la lame d'extrémité 8 de l'écran 2.

La longueur de course de déplacement de l'écran 2 peut être déterminée, notamment, en fonction de l'angle de rotation du tube d'enroulement 4, et en particulier par un ou plusieurs capteurs du moteur électrique 16 permettant de déterminer l'angle de rotation du rotor.

Ici, l'étape de détermination E24 est mise en œuvre au moyen de l'unité électronique de contrôle 15, et en particulier du dispositif de mesure 22 et du microcontrôleur 27 de l'unité électronique de contrôle 15.

Avantageusement, le procédé de commande met en œuvre l'étape de détermination E24 d'un écart d'intensité ΔI par rapport à la première valeur d'intensité I1 mesurée, lorsqu'une augmentation de la valeur d'intensité I traversant le moteur électrique 16 est déterminée, lors de l'étape de détermination E23.

Ainsi, le procédé de commande ne met en œuvre l'étape de détermination E24 que si une augmentation de la valeur d'intensité I est déterminée sur la base des étapes de mesure E21, E22.

De cette manière, la première valeur d'intensité I1 mesurée correspond à une valeur d'intensité de référence dès qu'une augmentation de la valeur d'intensité I traversant le moteur électrique 16 est déterminée.

En outre, la détermination d'une augmentation de la valeur d'intensité I traversant le moteur électrique 16 permet de déclencher la surveillance de présence ou d'absence d'un obstacle ou d'une fin de course par le dispositif de détection 27, à partir de l'instant de la première valeur d'intensité I1 mesurée.

Par ailleurs, l'étape de détermination E24 d'un écart d'intensité ΔI, par rapport à la première valeur d'intensité I1 mesurée, est mise en œuvre, seulement, suite à la détermination d'une augmentation de la valeur intensité I traversant le moteur électrique 16, de sorte à limiter le nombre de calculs mis en œuvre par l'unité électronique de contrôle 15, et en particulier par le microcontrôleur 27, pour minimiser le taux d'occupation des ressources de celle-ci.

L'adaptation du nombre d'étapes additionnelles de mesure E22 d'une autre valeur d'intensité I2, I3, I4, I5 par le dispositif de mesure 28 en fonction de la vitesse de rotation de l'arbre de sortie 20 de l'actionneur électromécanique 11 permet, en outre, de prendre en considération la même première valeur d'intensité I1 mesurée, quelle que soit la vitesse de rotation de l'arbre de sortie 20 de l'actionneur électromécanique 11.

Dans un mode de réalisation, la détermination de l'augmentation de la valeur d'intensité I traversant le moteur électrique 16 est mise en œuvre par une sous-étape de comparaison des valeurs d'intensité I1, I2, I3, I4, I5 mesurées et, en particulier, par itérations successives de la dernière valeur d'intensité mesurée par rapport à la valeur d'intensité mesurée précédemment.

Ici, lors de l'étape de détermination E23, la première valeur d'intensité I1 mesurée lors de l'étape de mesure E21 est comparée à la première autre valeur d'intensité I2 mesurée lors de la première étape de mesure additionnelle E22 pour déterminer si la première valeur d'intensité I1 mesurée est inférieure à la première autre valeur d'intensité I2 mesurée.

Puis, la première autre valeur d'intensité I2 mesurée lors de la première étape de mesure additionnelle E22 est comparée à la deuxième autre valeur d'intensité I3 mesurée lors de la deuxième étape de mesure additionnelle E22 pour déterminer si la première autre valeur d'intensité I2 mesurée est inférieure à la deuxième autre valeur d'intensité I3 mesurée.

Puis, l'étape de détermination E23 d'une évolution de la valeur d'intensité I met en œuvre des comparaisons similaires pour les autres valeurs d'intensité I4, I5 mesurées.

En outre, dans le cas où une diminution de la valeur d'intensité I traversant le moteur électrique 16 est déterminée, lors de l'étape de détermination E23, le procédé de commande met en œuvre, de nouveau, l'étape de mesure E21 de la première valeur d'intensité I1.

Ainsi, l'étape de mesure E21 de la première valeur d'intensité I1 est réinitialisée si une diminution de la valeur d'intensité I traversant le moteur électrique 16 est déterminée lors de l'étape de détermination E23.

Dans un mode de réalisation, suite à l'étape de détermination E24 d'un écart d'intensité ΔI par rapport à la première valeur d'intensité I1 mesurée, le procédé de commande comprend une étape de détermination E28 d'une évolution de l'écart d'intensité ΔI.

Ici, l'étape de détermination E28 est mise en œuvre au moyen de l'unité électronique de contrôle 15, et en particulier du dispositif de mesure 22 et du microcontrôleur 27 de l'unité électronique de contrôle 15.

Préférentiellement, l'étape de détermination E24 d'un écart d'intensité ΔI par rapport à la première valeur d'intensité I1 mesurée est mise en œuvre périodiquement, tant que le résultat de l'étape de détermination E28 d'une évolution de l'écart d'intensité ΔI correspond à une augmentation de la valeur d'intensité I traversant le moteur électrique 16.

A titre d'exemple nullement limitatif, l'étape de détermination E24 d'un écart d'intensité ΔI par rapport à la première valeur d'intensité I1 est mise en œuvre toutes les 5 millisecondes, suite à l'instant de mesure de la première valeur d'intensité I1.

Avantageusement, l'étape de détermination E24 d'un écart d'intensité ΔI est mise en œuvre à partir d'une sous-étape de mesure E241 d'une autre valeur d'intensité I_{Δ1}, I_{Δ2}, I_{Δ3} traversant le moteur électrique 16 par le dispositif de mesure 28, suite à l'écoulement d'une période de temps Δt1, Δt2, Δt3 démarrant à partir de l'instant de mesure de la première valeur d'intensité I1, puis, d'une sous-étape de comparaison E242 de l'autre valeur d'intensité I_{Δ1}, I_{Δ2}, I_{Δ3} mesurée par rapport à la première valeur d'intensité I1 mesurée.

Ici, la valeur d'intensité I_{Δ1} correspond à la différence entre la première valeur d'intensité I1 mesurée et la deuxième valeur d'intensité I2 mesurée. La valeur d'intensité I_{Δ2} correspond à la différence entre la première valeur d'intensité I1 mesurée et la troisième valeur d'intensité I3 mesurée. Puis, les valeurs d'intensité I_{Δn} sont obtenues par des comparaisons similaires par rapport à la première valeur d'intensité I1 mesurée.

Dans un mode de réalisation, la sous-étape de mesure E241 de l'autre valeur d'intensité I_{Δ1}, I_{Δ2}, I_{Δ3} traversant le moteur électrique 16, permettant la détermination d'un écart d'intensité ΔI par rapport à la première valeur d'intensité I1 mesurée, est mise en œuvre selon la périodicité de mise en œuvre de l'étape de détermination E24 d'un écart d'intensité ΔI par rapport à la première valeur d'intensité I1.

Préférentiellement, l'étape de détermination E24 d'un écart d'intensité ΔI par rapport à la première valeur d'intensité I1 mesurée est mise en œuvre périodiquement pendant une période de temps prédéterminée T_{L} démarrant à partir de l'instant de mesure de la première valeur d'intensité I1.

Ainsi, dans le cas où la période de temps prédéterminée T_{L} est écoulée, sans que l'étape de détermination E24 détecte un écart d'intensité ΔI supérieur à une valeur seuil d'intensité S prédéterminée, cela signifie que le procédé de commande a abouti à une absence de détermination d'un obstacle ou d'une fin de course au cours de la période de temps prédéterminée T_{L}.

En outre, dans le cas où la période de temps prédéterminée T_{L} est écoulée, sans que l'étape de détermination E24 détecte un écart d'intensité ΔI supérieur à une valeur seuil d'intensité S prédéterminée, le procédé de commande met en œuvre de nouveau l'étape de mesure E21 de la première valeur d'intensité I1 traversant le moteur électrique 16.

Dans un mode de réalisation, l'étape de détermination E24 d'un écart d'intensité ΔI par rapport à la première valeur d'intensité I1 mesurée est mise en œuvre périodiquement pendant la période de temps prédéterminée T_{L} démarrant à partir de l'instant de mesure de la première valeur d'intensité I1, lorsqu'une augmentation de la valeur d'intensité I traversant le moteur électrique 16 est déterminée, lors de l'étape de détermination E23.

Puis, le procédé de commande comprend une étape de sélection E25 de l'une des valeurs seuils d'intensité S en fonction de la période de temps Δt écoulée.

Ici, l'étape de sélection E25 est mise en œuvre au moyen de l'unité électronique de contrôle 15, et en particulier du microcontrôleur 27 de l'unité électronique de contrôle 15.

Avantageusement, l'instant de mesure de la première valeur d'intensité I1, à partir duquel l'étape de détermination E24 d'un écart d'intensité ΔI est mise en œuvre, correspond à un instant de démarrage d'une recherche de détection d'obstacle ou de fin de course selon une sensibilité de détection prédéfinie.

La sensibilité de détection prédéfinie peut être sélectionnée, notamment, en fonction de la position de l'écran 2, ou en fonction d'une saisie réalisée par l'utilisateur au travers de l'unité de commande locale 12 ou de l'unité de commande centrale 13.

Avantageusement, les valeurs seuils d'intensité S stockées dans la mémoire de l'unité électronique de contrôle 15 et utilisées lors de l'étape de sélection E25 sont fixées et suivent un profil prédéterminé entre un instant de début, l'instant de début correspondant à l'instant de mesure de la première valeur d'intensité I1, et un instant de fin, l'instant de fin correspondant à l'instant de fin de l'écoulement de la période de temps prédéterminée T_{L} démarrant à partir de l'instant de mesure de la première valeur d'intensité I1.

Préférentiellement, le profil de valeurs seuils d'intensité S stockées dans une mémoire de l'unité électronique de contrôle 15 et utilisées lors de l'étape de sélection E25 comprend au moins une première phase où les valeurs seuils d'intensité S sont identiques pendant une première période de temps prédéterminée Sa à partir de l'instant de mesure de la première valeur d'intensité I1, et une deuxième phase où les valeurs seuils d'intensité S sont décroissantes pendant une deuxième période de temps prédéterminée Sb suivant la première période de temps prédéterminée Sa.

Ici et de manière nullement limitative, la première période de temps prédéterminée Sa est de l'ordre de 100 millisecondes, et la deuxième période de temps prédéterminée Sb est de l'ordre de 200 millisecondes.

Les valeurs seuils d'intensité S de la première phase du profil de valeurs seuils d'intensité S stockées dans la mémoire de l'unité électronique de contrôle 15 et utilisées lors de l'étape de sélection E25 sont identiques de sorte à permettre la détection d'une fin de course ou d'un obstacle rigide, tels que par exemple un point dur dans les glissières latérales 6 lors du passage des lames de l'écran 2 dans celles-ci, ou un coincement des lames de l'écran 2 entre elles, ou encore un à-coup lors de l'enroulement de la ou les articulations 10 et de la lame d'extrémité supérieure de l'écran 2 autour du tube d'enroulement 4.

Les valeurs seuils d'intensité S de la deuxième phase du profil de valeurs seuils d'intensité S stockées dans la mémoire de l'unité électronique de contrôle 15 et utilisées lors de l'étape de sélection E25 sont décroissantes de sorte à permettre la détection d'un obstacle souple, tel que par exemple la retenue de lames de l'écran 2 dans les glissières latérales 6 par le gel.

Les valeurs seuils d'intensité S de la deuxième phase du profil sont décroissantes jusqu'à une valeur seuil d'intensité minimale Smin.

La valeur seuil d'intensité minimale Smin correspond à une valeur seuil d'intensité S supérieure à la variation de couple engendrée par le dépilement des lames de l'écran 2 lors de l'enroulement de l'écran 2 depuis la fin de course basse.

La pente d'une droite D reliant le point représentatif de la première valeur d'intensité I1 au point représentatif de la valeur seuil d'intensité minimale Smin, à la figure 7, correspond à la pente minimale de l'écart d'intensité ΔI pouvant être utilisé pour la détermination d'un obstacle par le dispositif de détection 27.

Avantageusement, le procédé de commande met en œuvre l'étape de sélection E25 de l'une des valeurs seuils d'intensité S lorsqu'une augmentation de l'écart d'intensité ΔI est déterminée, lors de l'étape de détermination E28 d'une évolution de l'écart d'intensité ΔI par rapport à la première valeur d'intensité I1 mesurée.

Ainsi, le procédé de commande ne met en œuvre l'étape de sélection E25 que si une augmentation de l'écart d'intensité ΔI est déterminée sur la base de l'étape de mesure E21 de la première valeur d'intensité I1 traversant le moteur électrique 16 et d'au moins une sous-étape de mesure E241 d'une autre valeur d'intensité I_{Δ1}, I_{Δ2}, I_{Δ3} traversant le moteur électrique 16 mise en œuvre au cours de l'étape de détermination E24 d'un écart d'intensité ΔI.

En outre, l'étape de sélection E25 de l'une des valeurs seuils d'intensité S est mise en œuvre, seulement, suite à la détermination d'une augmentation de l'écart d'intensité ΔI, de sorte à limiter le nombre de calculs mis en œuvre par l'unité électronique de contrôle 15, et en particulier du microcontrôleur 27, pour minimiser le taux d'occupation des ressources de celle-ci.

Dans un mode de réalisation, la détermination de l'augmentation de l'écart d'intensité ΔI est mise en œuvre par une sous-étape de comparaison E242 des valeurs d'intensité I1, I_{Δ1}, I_{Δ2}, I_{Δ3} mesurées, et en particulier par itérations successives de la dernière valeur d'intensité mesurée par rapport à la valeur d'intensité mesurée précédemment.

Ici, lors de l'étape de détermination E28 d'une évolution de l'écart d'intensité ΔI, la comparaison de la première valeur d'intensité I1 mesurée lors de l'étape de mesure E21 à la première autre valeur d'intensité I_{Δ1} mesurée lors de la sous-étape de mesure E241 est analysée pour déterminer si la première valeur d'intensité I1 mesurée est inférieure à la première autre valeur d'intensité I_{Δ1} mesurée.

Puis, la comparaison de la première autre valeur d'intensité I_{Δ1} mesurée lors de la première sous-étape de mesure E241 à une deuxième autre valeur d'intensité I_{Δ2} mesurée lors d'une deuxième sous-étape de mesure E241 est analysée pour déterminer si la première autre valeur d'intensité I_{Δ1} mesurée est inférieure à la deuxième autre valeur d'intensité I_{Δ2} mesurée.

Puis, l'étape de détermination E28 d'une évolution de l'écart d'intensité ΔI analyse des comparaisons similaires pour d'autres valeurs d'intensité I_{Δn} mesurées, tant qu'une augmentation de l'écart d'intensité ΔI est déterminée et que la période de temps prédéterminée T_{L} n'est pas écoulée.

En outre, dans le cas où une diminution de l'écart d'intensité ΔI est déterminée, lors de l'étape de détermination E28 d'une évolution de l'écart d'intensité ΔI, le procédé de commande met en œuvre de nouveau l'étape de mesure E21 de la première valeur d'intensité I1 traversant le moteur électrique 16.

Ainsi, l'étape de mesure E21 de la première valeur d'intensité I1 traversant le moteur électrique 16 est réinitialisée si une diminution de l'écart d'intensité ΔI est déterminée, lors de l'étape de détermination E28 d'une évolution de l'écart d'intensité ΔI.

Le procédé de commande comprend, ensuite, une étape de comparaison E26 de l'écart d'intensité ΔI déterminé par rapport à la valeur seuil d'intensité S sélectionnée, et une étape de détermination E27 de présence ou d'absence d'un obstacle ou d'une fin de course en fonction du résultat de l'étape de comparaison E26.

Ici, l'étape de comparaison E26 et l'étape de détermination E27 sont mises en œuvre au moyen de l'unité électronique de contrôle 15, et en particulier du microcontrôleur 27 de l'unité électronique de contrôle 15.

La présence d'un obstacle ou d'une fin de course est déterminée lorsque l'écart d'intensité ΔI déterminé est supérieur ou égal à la valeur seuil d'intensité S sélectionnée.

Et l'absence d'un obstacle ou d'une fin de course est déterminée lorsque l'écart d'intensité ΔI déterminé est inférieur à la valeur seuil d'intensité S sélectionnée.

La surveillance du couple généré par le moteur électrique 16 de l'actionneur électromécanique 11 au travers de la mesure de l'intensité I traversant le moteur électrique 16 par le dispositif de mesure 28 permet de garantir la fiabilité de détermination d'absence ou de présence d'un obstacle ou d'une fin de course.

L'utilisation de la mesure de l'intensité I traversant le moteur électrique 16 permet de garantir la réactivité de détermination d'absence ou de présence d'un obstacle ou d'une fin de course et de s'affranchir d'incertitudes de mesure liées à une chaîne de mesure comportant un ou plusieurs capteurs.

L'utilisation de la mesure de l'intensité I traversant le moteur électrique 16 pour réaliser les mesures d'intensité I1, I2, I3, I4, I5, I_{Δ1}, I_{Δ2}, I_{Δ3} permet de déterminer une fréquence d'échantillonnage en fonction de la précision souhaitée de détermination d'absence ou de présence d'un obstacle ou d'une fin de course. Cette fréquence d'échantillonnage de l'intensité I traversant le moteur électrique 16 est ainsi indépendante de la tension du réseau d'alimentation électrique du secteur, et en particulier de sa fréquence.

Préférentiellement, l'étape de détermination E24 d'un écart d'intensité ΔI par rapport à la première valeur d'intensité mesurée I1 est mise en œuvre périodiquement, tant que le résultat de l'étape de détermination E27 de présence ou d'absence d'un obstacle ou d'une fin de course est différent d'un obstacle ou d'une fin de course détecté.

Avantageusement, le procédé de commande comprend également une étape de détermination E11 du sens de rotation de l'arbre de sortie 20 du moteur électrique 16, une étape de détermination E12 de la position de l'écran 2 du dispositif d'occultation 3 et une étape de détermination E13 de plusieurs portions de la course de déplacement de l'écran 2, lors de l'enroulement de l'écran 2 et lors du déroulement de l'écran 2.

Dans un premier mode de réalisation, au moins les étapes de détermination E24 d'un écart d'intensité ΔI, de sélection E25 de l'une des valeurs seuils d'intensité S, de comparaison E26 de l'écart d'intensité ΔI déterminé par rapport à la valeur seuil d'intensité S sélectionnée et de détermination E27 de présence ou d'absence d'un obstacle ou d'une fin de course sont mises en œuvre au cours d'au moins une portion de la course de déplacement de l'écran 2, lors de l'enroulement de l'écran 2 ou lors du déroulement de l'écran 2.

Dans un tel cas, ces étapes E24, E25, E26, E27 permettant de déterminer la présence ou l'absence d'un obstacle ou d'une fin de course sont mises en œuvre au cours d'une portion de la course de déplacement de l'écran 2, suite à la mise en œuvre des étapes E11, E12, E13 permettant de déterminer la position de l'écran 2 lors d'un mouvement de celui-ci provoqué par l'actionneur électromécanique 11.

Ce premier mode de réalisation est, préférentiellement, mis en œuvre suite à la détermination des butées de fins de course haute et basse permettant de délimiter la course de déplacement de l'écran 2 du dispositif d'occultation 3.

La détermination des butées de fins de course haute et basse peut être mise en œuvre soit automatiquement soit manuellement. La détermination des butées de fins de course haute et basse de manière automatique est mise en œuvre, lors de la mise en service de l'installation domotique, par une séquence de mouvements de l'écran 2 jusqu'à la détection d'un obstacle en partie haute de l'installation domotique puis jusqu'à la détection d'un obstacle en partie basse de l'installation domotique. La détermination des butées de fins de course haute et basse de manière manuelle est mise en œuvre, lors de la mise en service de l'installation domotique, par un déplacement de l'écran 2 jusqu'à une position haute définie par l'utilisateur en appuyant, par exemple, sur un bouton de la télécommande 14, et de même jusqu'à une position basse.

Avantageusement, au moins les étapes de détermination E24 d'un écart d'intensité ΔI, de sélection E25 de l'une des valeurs seuils d'intensité S, de comparaison E26 de l'écart d'intensité ΔI déterminé par rapport à la valeur seuil d'intensité S sélectionnée et de détermination E27 de présence ou d'absence d'un obstacle ou d'une fin de course sont mises en œuvre au cours d'une portion de démarrage de la course de déplacement de l'écran 2, lors de l'enroulement de l'écran 2 ou lors de son déroulement, suite à l'atteinte d'une fin de course.

Dans un tel cas, au cours d'une ou plusieurs autres portions de la course de déplacement de l'écran 2, la valeur seuil d'intensité S est fixe.

Ainsi, au cours de la ou les autres portions de la course de déplacement de l'écran 2, la valeur seuil d'intensité S est indépendante de la période de temps Δt écoulée à partir de la première valeur d'intensité I1 mesurée.

Préférentiellement, la valeur seuil d'intensité S fixe de la ou des autres portions de la course de déplacement de l'écran 2 est inférieure ou égale à la plus petite des valeurs seuils d'intensité S utilisées au cours de la portion de démarrage de la course de déplacement de l'écran 2.

Ainsi, la détermination de présence ou d'absence d'un obstacle ou d'une fin de course par le dispositif de détection 27 est mise en œuvre avec un seuil de sensibilité relativement haut lors de la ou les autres portions de la course de déplacement de l'écran 2.

Avantageusement, la ou les autres portions de la course de déplacement de l'écran 2 correspondent, notamment, aux zones d'accostage sur les fins de course haute et basse.

En outre, la détermination de présence ou d'absence d'un obstacle ou d'une fin de course par le dispositif de détection 27 est mise en œuvre avec un seuil de sensibilité bas lors de la portion de démarrage de la course de déplacement de l'écran 2, de sorte à éviter des déclenchements intempestifs du dispositif de détection 27 provoquant l'arrêt du dispositif d'entraînement motorisé 5.

Dans un deuxième mode de réalisation, au moins les étapes de détermination E24 d'un écart d'intensité ΔI, de sélection E25 de l'une des valeurs seuils d'intensité S, de comparaison E26 de l'écart d'intensité ΔI déterminé par rapport à la valeur seuil d'intensité S sélectionnée et de détermination E27 de présence ou d'absence d'un obstacle ou d'une fin de course sont mises en œuvre tout au long de la course de déplacement de l'écran 2, lors de l'enroulement de l'écran 2 ou lors de son déroulement.

Dans un tel cas, ces étapes E24, E25, E26, E27 permettant de déterminer la présence ou l'absence d'un obstacle ou d'une fin de course sont mises en œuvre sur la longueur totale de la course de déplacement de l'écran 2.

Ce deuxième mode de réalisation est, préférentiellement, mis en œuvre lors de l'installation du dispositif d'occultation 3, et en particulier avant la détermination des butées de fins de course haute et basse permettant de délimiter la course de déplacement de l'écran 2 du dispositif d'occultation 3.

Avantageusement, la première valeur d'intensité I1 mesurée, la ou les autres valeurs d'intensité I_{Δ1}, I_{Δ2}, I_{Δ3} mesurées permettant la détermination d'un écart d'intensité ΔI par rapport à la première valeur d'intensité I1 mesurée et la détermination d'une évolution de l'écart d'intensité ΔI par rapport à la première valeur d'intensité I1 mesurée, ainsi que la ou les autres valeurs d'intensité I2, I3, I4, I5 mesurées permettant la détermination d'une évolution de la valeur d'intensité I traversant le moteur électrique 16 sont mémorisées temporairement dans une mémoire tampon de l'unité électronique de contrôle 15, et en particulier du microcontrôleur 27.

Grâce à la présente invention, le procédé de commande permet de déterminer l'atteinte ou non des fins de course de déplacement de l'écran, ainsi que la présence ou l'absence d'obstacle par la surveillance d'écarts d'intensité par rapport à une première valeur d'intensité traversant le moteur électrique.

De cette manière, le procédé de commande permet de déterminer la présence ou l'absence d'un obstacle ou d'une fin de course de manière dynamique en comparant des écarts d'intensité déterminés à partir d'une première valeur d'intensité traversant le moteur électrique par rapport à une valeur seuil d'intensité sélectionnée en fonction de la période de temps écoulée entre l'instant de mesure de la première valeur d'intensité et l'instant de détermination d'un écart d'intensité.

Par conséquent, le procédé de commande permet de garantir la protection du dispositif d'entraînement motorisé ainsi que de l'installation domotique, tout en limitant les arrêts intempestifs de déplacement de l'écran du dispositif d'occultation.

La présente invention vise également un produit programme d'ordinateur comprenant des instructions de codes agencées pour mettre en œuvre les étapes du procédé de commande conforme à l'invention, tel que décrit précédemment.

En outre, l'unité électronique de contrôle comprend le microcontrôleur. Le microcontrôleur comporte en mémoire les instructions de code du produit programme d'ordinateur. Et l'unité électronique de contrôle est configurée pour au moins déterminer un écart d'intensité, sélectionner l'une des valeurs seuils d'intensité, comparer l'écart d'intensité déterminé par rapport à la valeur seuil d'intensité sélectionnée et déterminer la présence ou l'absence d'un obstacle ou d'une fin de course.

De nombreuses modifications peuvent être apportées aux exemples de réalisation décrits précédemment sans sortir du cadre de l'invention défini par les revendications.

En particulier, le moteur électrique de l'actionneur électromécanique peut être du type asynchrone triphasé ou encore à courant continu.

## Revendications

1. Procédé de commande en fonctionnement d'un dispositif d'entraînement motorisé (5) d'une installation domotique de fermeture ou de protection solaire,
l'installation domotique de fermeture ou de protection solaire comprenant un dispositif d'occultation (3),
le dispositif d'occultation (3) comprenant au moins :
- un écran (2), et
- un tube d'enroulement (4),
le dispositif d'entraînement motorisé (5) comprenant au moins :
- un actionneur électromécanique (11) permettant d'enrouler et de dérouler l'écran (2) sur le tube d'enroulement (4), entre une position enroulée et une position déroulée,
l'actionneur électromécanique (11) comprenant au moins :
- un moteur électrique (16),
- un arbre de sortie (20) relié au tube d'enroulement (4) du dispositif d'occultation (3), et
- une unité électronique de contrôle (15),
l'unité électronique de contrôle (15) comprenant au moins :
- un dispositif de mesure (28) d'une valeur d'intensité (I) d'un courant électrique traversant le moteur électrique (16),
- une mémoire (27) stockant une pluralité de valeurs seuils d'intensité (S), et
- un dispositif (27) de détection d'obstacle et de fins de course, lors de l'enroulement de l'écran (2) et lors du déroulement de l'écran (2),
ledit procédé comprend au moins :
- une étape de mesure (E21) d'une première valeur d'intensité (I1) du courant électrique traversant le moteur électrique (16) par le dispositif de mesure (28),
**caractérisé en ce que** ledit procédé comprend au moins :
- une étape de détermination (E24) d'un écart d'intensité (ΔI) par rapport à la première valeur d'intensité (I1) mesurée, suite à l'écoulement d'une période de temps (Δt) démarrant à partir de l'instant de mesure de la première valeur d'intensité (I1),
- une étape de sélection (E25) de l'une des valeurs seuils d'intensité (S) en fonction de la période de temps (Δt) écoulée,
- une étape de comparaison (E26) de l'écart d'intensité (ΔI) déterminé par rapport à la valeur seuil d'intensité (S) sélectionnée, et
- une étape de détermination (E27) de présence ou d'absence d'un obstacle ou d'une fin de course par le dispositif de détection (27) en fonction du résultat de l'étape de comparaison (E26).

2. Procédé de commande en fonctionnement d'un dispositif d'entraînement motorisé (5) d'une installation domotique de fermeture ou de protection solaire selon la revendication 1, **caractérisé en ce que** ledit procédé comprend :
- une ou plusieurs étapes additionnelles de mesure (E22) d'une autre valeur d'intensité (I2, I3, I4, I5) traversant le moteur électrique (16) par le dispositif de mesure (28), suite à la mise en œuvre de l'étape de mesure (E21) de la première valeur d'intensité (I1) traversant le moteur électrique (16),
- une étape de détermination (E23) d'une évolution de la valeur d'intensité (I) traversant le moteur électrique (16) au travers des étapes de mesure (E21, E22) d'une valeur d'intensité (I1, I2, I3, I4, I5) traversant le moteur électrique (16),
et **en ce que**, ledit procédé met en œuvre l'étape de détermination (E24) d'un écart d'intensité (ΔI) par rapport à la première valeur d'intensité (I1) mesurée lorsque l'étape de détermination (E23) d'une évolution de la valeur d'intensité (I) traversant le moteur électrique (16) détermine une augmentation de la valeur d'intensité (I) traversant le moteur électrique (16).

3. Procédé de commande en fonctionnement d'un dispositif d'entraînement motorisé (5) d'une installation domotique de fermeture ou de protection solaire selon la revendication 2, **caractérisé en ce que**, dans le cas où une diminution de la valeur d'intensité (I) traversant le moteur électrique (16) est déterminée lors de l'étape de détermination (E23) d'une évolution de la valeur d'intensité (I) traversant le moteur électrique (16), le procédé de commande met en œuvre de nouveau l'étape de mesure (E21) de la première valeur d'intensité (I1) traversant le moteur électrique (16).

4. Procédé de commande en fonctionnement d'un dispositif d'entraînement motorisé (5) d'une installation domotique de fermeture ou de protection solaire selon l'une quelconque des revendications 1 à 3, **caractérisé en ce que**, suite à l'étape de détermination (E24) d'un écart d'intensité (ΔI) par rapport à la première valeur d'intensité (I1) mesurée, ledit procédé comprend une étape de détermination (E28) d'une évolution de l'écart d'intensité (ΔI) par rapport à la première valeur d'intensité (I1) mesurée.

5. Procédé de commande en fonctionnement d'un dispositif d'entraînement motorisé (5) d'une installation domotique de fermeture ou de protection solaire selon la revendication 4, **caractérisé en ce que** l'étape de détermination (E24) d'un écart d'intensité (ΔI) par rapport à la première valeur d'intensité (I1) mesurée est mise en œuvre périodiquement, tant que le résultat de l'étape de détermination (E28) d'une évolution de l'écart d'intensité (ΔI) correspond à une augmentation de la valeur d'intensité (I) traversant le moteur électrique (16).

6. Procédé de commande en fonctionnement d'un dispositif d'entraînement motorisé (5) d'une installation domotique de fermeture ou de protection solaire selon l'une quelconque des revendications 1 à 5, **caractérisé en ce que** l'étape de détermination (E24) d'un écart d'intensité (ΔI) par rapport à la première valeur d'intensité (I1) mesurée est mise en œuvre périodiquement, tant que le résultat de l'étape de détermination (E27) de présence ou d'absence d'un obstacle ou d'une fin de course est différent d'un obstacle ou d'une fin de course détecté.

7. Procédé de commande en fonctionnement d'un dispositif d'entraînement motorisé (5) d'une installation domotique de fermeture ou de protection solaire selon l'une quelconque des revendications 1 à 6, **caractérisé en ce que** l'étape de détermination (E24) d'un écart d'intensité (ΔI) par rapport à la première valeur d'intensité (I1) mesurée est mise en œuvre périodiquement pendant une période de temps prédéterminée (TL) démarrant à partir de l'instant de mesure de la première valeur d'intensité (I1).

8. Procédé de commande en fonctionnement d'un dispositif d'entraînement motorisé (5) d'une installation domotique de fermeture ou de protection solaire selon l'une quelconque des revendications 1 à 7, **caractérisé en ce que** l'étape de mesure (E21) de la première valeur d'intensité (I1) traversant le moteur électrique (16) est mise en œuvre suite à l'écoulement d'une période de temps prédéterminée (Td) démarrant à partir de l'instant de commande de démarrage du moteur électrique (16).

9. Procédé de commande en fonctionnement d'un dispositif d'entraînement motorisé (5) d'une installation domotique de fermeture ou de protection solaire selon l'une quelconque des revendications 1 à 8, **caractérisé en ce que** ledit procédé comprend également :
- une étape de détermination (E11) du sens de rotation de l'arbre de sortie (20) du moteur électrique (16),
- une étape de détermination (E12) de la position de l'écran (2) du dispositif d'occultation (3),
- une étape de détermination (E13) de plusieurs portions de la course de déplacement de l'écran (2) lors de l'enroulement de l'écran (2) et lors du déroulement de l'écran (2),
et **en ce qu'**au moins les étapes de détermination (E24) d'un écart d'intensité (ΔI), de sélection (E25) de l'une des valeurs seuils d'intensité (S), de comparaison (E26) de l'écart d'intensité (ΔI) déterminé par rapport à la valeur seuil d'intensité (S) sélectionnée et de détermination (E27) de présence ou d'absence d'un obstacle ou d'une fin de course sont mises en œuvre au cours d'au moins une portion de la course de déplacement de l'écran (2), lors de l'enroulement de l'écran (2) ou lors du déroulement de l'écran (2).

10. Procédé de commande en fonctionnement d'un dispositif d'entraînement motorisé (5) d'une installation domotique de fermeture ou de protection solaire selon la revendication 9, **caractérisé en ce qu'**au moins lesdites étapes de détermination (E24) d'un écart d'intensité (ΔI), de sélection (E25) de l'une des valeurs seuils d'intensité (S), de comparaison (E26) de l'écart d'intensité (ΔI) déterminé par rapport à la valeur seuil d'intensité (S) sélectionnée et de détermination (E27) de présence ou d'absence d'un obstacle ou d'une fin de course sont mises en œuvre au cours d'une portion de démarrage de la course de déplacement de l'écran (2), lors de l'enroulement de l'écran (2) ou lors du déroulement de l'écran (2), suite à l'atteinte d'une fin de course.

11. Dispositif d'entraînement motorisé (5) d'une installation domotique de fermeture ou de protection solaire, **caractérisé en ce que** l'unité électronique de contrôle (15) est configurée pour mettre en œuvre le procédé de commande conforme à l'une quelconque des revendications 1 à 10.

12. Dispositif d'entraînement motorisé (5) d'une installation domotique de fermeture ou de protection solaire selon la revendication 11, **caractérisé en ce que** le moteur électrique (16) de l'actionneur électromécanique (11) est de type sans balais à commutation électronique.

## Patentansprüche

1. Verfahren zum Steuern des Betriebs einer motorisierten Antriebsvorrichtung (5) einer Schließ- oder Sonnenschutzanlage für die Gebäudeautomatisierung,
wobei die Schließ- oder Sonnenschutzanlage für die Gebäudeautomatisierung eine Verdeckvorrichtung (3) aufweist,
wobei die Verdeckvorrichtung (3) wenigstens Folgendes enthält:
- eine Abschirmung (2) und
- ein Aufwickelrohr (4),
wobei die motorisierte Antriebsvorrichtung (5) wenigstens Folgendes enthält:
- einen elektromechanischen Aktor (11), der das Aufwickeln und Abwickeln der Abschirmung (2) auf das Aufwickelrohr (4) zwischen einer aufgewickelten Position und einer abgewickelten Position ermöglicht,
wobei der elektromechanische Aktor (11) wenigstens Folgendes enthält:
- einen Elektromotor (16),
- eine Ausgangswelle (20), die mit dem Aufwickelrohr (4) der Verdeckvorrichtung (3) verbunden ist, und
- eine elektronische Steuereinheit (15),
wobei die elektronische Steuereinheit (15) wenigstens Folgendes enthält:
- eine Vorrichtung (28) zum Messen eines Wertes der Stromstärke (I) eines durch den Elektromotor (16) fließenden elektrischen Stroms,
- einen Speicher (27), der mehrere Stromstärke-Schwellenwerte (S) speichert, und
- eine Vorrichtung (27) zum Detektieren eines Hindernisses und des Bahnendes beim Aufwickeln der Abschirmung (2) und beim Abwickeln der Abschirmung (2),
wobei das Verfahren wenigstens Folgendes umfasst:
- einen Schritt (E21) des Messens eines ersten Stromstärkewerts (I1) des durch den Elektromotor (16) fließenden elektrischen Stroms durch die Messvorrichtung (28)
**dadurch gekennzeichnet, dass** das Verfahren wenigstens Folgendes umfasst:
- einen Schritt (E24) des Bestimmens eines Abstands (AI) zu dem ersten gemessenen Stromstärkewert (I1) nach Ablauf einer Zeitdauer (Δt), die zum Zeitpunkt des Messens des ersten Stromstärkewerts (I1) beginnt,
- einen Schritt (E25) des Auswählens eines der Stromstärke-Schwellenwerte (S) als Funktion der abgelaufenen Zeitdauer (Δt),
- einen Schritt (E26) des Vergleichens des bestimmten Stromstärkewerts (AI) mit dem ausgewählten Stromstärke-Schwellenwert (S), und
- einen Schritt (E27) des Bestimmens des Vorhandenseins oder Fehlens eines Hindernisses oder eines Bahnendes durch die Detektionsvorrichtung (27) als Funktion des Ergebnisses des Vergleichsschrittes (E26).

2. Verfahren zum Steuern des Betriebs einer motorisierten Antriebsvorrichtung (5) einer Schließ- oder Sonnenschutzanlage für die Gebäudeautomatisierung nach Anspruch 1, **dadurch gekennzeichnet, dass** das Verfahren Folgendes umfasst:
- einen oder mehrere zusätzliche Schritte (E22) des Messens eines anderen Stromstärkewerts (I2, I3, I4, I5) des durch den Elektromotor (16) fließenden Stroms durch die Messvorrichtung (28) nach der Ausführung des Schrittes (E21) des Messens des ersten Stromstärkewertes (I1) des durch den Elektromotor (16) fließenden Stroms,
- einen Schritt (E23) des Bestimmens einer Entwicklung des Stromstärkewerts (I) des durch den Elektromotor (16) fließenden Stroms über die Schritte (E21, E22) des Messens eines Stromstärkewerts (I1, I2, I3, I4, I5) des durch den Elektromotor (16) fließenden Stroms,
und dass das Verfahren, das einen Schritt (E24) des Bestimmens eines Stromstärkeabstands (AI) in Bezug auf den ersten Stromstärkewert (I1), der im Schritt (E23) des Bestimmens einer Entwicklung des Stromstärkewerts (I) des durch den Elektromotor (16) fließenden Stroms gemessen wird, ausführt, eine Zunahme des Stromstärkewerts (I) des durch den Elektromotor (16) fließenden Stroms feststellt.

3. Verfahren zum Steuern des Betriebs einer motorisierten Antriebsvorrichtung (5) einer Schließ- oder Sonnenschutzanlage für die Gebäudeautomatisierung nach Anspruch 2, **dadurch gekennzeichnet, dass** das Steuerverfahren in dem Fall, in dem eine Abnahme des Stromstärkewerts (I) des durch den Elektromotor (16) fließenden Stroms im Schritt (E23) des Bestimmens einer Entwicklung des Stromstärkewerts (I) des durch den Elektromotor (16) fließenden Stroms festgestellt wird, erneut den Schritt (E21) des Messens des ersten Stromstärkewerts (I1) des durch den Elektromotor (16) fließenden Stroms ausführt.

4. Verfahren zum Steuern des Betriebs einer motorisierten Antriebsvorrichtung (5) einer Schließ- oder Sonnenschutzanlage für die Gebäudeautomatisierung nach einem der Ansprüche 1 bis 3, **dadurch gekennzeichnet, dass** nach dem Schritt (E24) des Bestimmens eine Stromstärkeabstands (AI) in Bezug auf den ersten gemessenen Stromstärkewert (I1) das Verfahren einen Schritt (E28) des Bestimmens einer Entwicklung des Stromstärkewerts (AI) in Bezug auf den ersten gemessenen Stromstärkewert (I1) umfasst.

5. Verfahren zum Steuern des Betriebs einer motorisierten Antriebsvorrichtung (5) einer Schließ- oder Sonnenschutzanlage für die Gebäudeautomatisierung nach Anspruch 4, **dadurch gekennzeichnet, dass** der Schritt (E24) des Bestimmens eines Stromstärkeabstands (AI) in Bezug auf den ersten gemessenen Stromstärkewert (I1) periodisch ausgeführt wird, so dass das Ergebnis des Schrittes (E28) des Bestimmens einer Entwicklung des Stromstärkeabstands (AI) einer Zunahme des Stromstärkewerts (I) des durch den Elektromotor (16) fließenden Stroms entspricht.

6. Verfahren zum Steuern des Betriebs einer motorisierten Antriebsvorrichtung (5) einer Schließ- oder Sonnenschutzanlage für die Gebäudeautomatisierung nach einem der Ansprüche 1 bis 5, **dadurch gekennzeichnet, dass** der Schritt (E24) des Bestimmens eines Stromstärkeabstands (AI) in Bezug auf den ersten gemessenen Stromstärkewert (I1) periodisch ausgeführt wird, so dass das Ergebnis des Schrittes (E27) des Bestimmens des Vorhandenseins oder Fehlens eines Hindernisses oder eines Bahnendes von einem detektierten Hindernis oder Bahnende verschieden ist.

7. Verfahren zum Steuern des Betriebs einer motorisierten Antriebsvorrichtung (5) einer Schließ- oder Sonnenschutzanlage für die Gebäudeautomatisierung nach einem der Ansprüche 1 bis 6, **dadurch gekennzeichnet, dass** der Schritt (E24) des Bestimmens eines Stromstärkeabstands (AI) in Bezug auf den ersten gemessenen Stromstärkewert (I1) während einer vorgegebenen Zeitdauer (T_{L}), die zu dem Zeitpunkt des Messens des ersten Stromstärkewerts (I1) beginnt, periodisch ausgeführt wird.

8. Verfahren zum Steuern des Betriebs einer motorisierten Antriebsvorrichtung (5) einer Schließ- oder Sonnenschutzanlage für die Gebäudeautomatisierung nach einem der Ansprüche 1 bis 7, **dadurch gekennzeichnet, dass** der Schritt (E21) des Messens des ersten Stromstärkewerts (I1) des durch den Elektromotor (16) fließenden Stroms nach Ablauf einer vorgegebenen Zeitdauer (Td), die zu dem Zeitpunkt des Steuerns des Startens des Elektromotors (16) beginnt, ausgeführt wird.

9. Verfahren zum Steuern des Betriebs einer motorisierten Antriebsvorrichtung (5) einer Schließ- oder Sonnenschutzanlage für die Gebäudeautomatisierung nach einem der Ansprüche 1 bis 8, **dadurch gekennzeichnet, dass** das Verfahren außerdem Folgendes umfasst:
- einen Schritt (E11) des Bestimmens der Drehrichtung der Ausgangswelle (20) des Elektromotors (16),
- einen Schritt (E12) des Bestimmens der Position der Abschirmung (2) der Verdeckvorrichtung (3),
- einen Schritt (E13) des Bestimmens mehrerer Abschnitte der Bahn der Verlagerung der Abschirmung (2) beim Aufwickeln der Abschirmung (2) und beim Abwickeln der Abschirmung (2),
und dass wenigstens der Schritt (E24) des Bestimmens eines Stromstärkeabstands (ΔI), der Schritt (E25) des Auswählens eines der Stromstärke-Schwellenwerte (S), der Schritt (E26) des Vergleichens des bestimmten Stromstärkeabstands (AI) mit dem ausgewählten Stromstärke-Schwellenwert (S) und der Schritt (E27) des Bestimmens des Vorhandenseins oder Fehlens eines Hindernisses oder eines Bahnendes wenigstens während eines Abschnitts der Bahn der Verlagerung der Abschirmung (2) ausgeführt werden, wenn die Abschirmung (2) aufgewickelt wird oder wenn die Abschirmung (2) abgewickelt wird.

10. Verfahren zum Steuern des Betriebs einer motorisierten Antriebsvorrichtung (5) einer Schließ- oder Sonnenschutzanlage für die Gebäudeautomatisierung nach Anspruch 9, **dadurch gekennzeichnet, dass** wenigstens der Schritt (E24) des Bestimmens eines Stromstärkeabstands (ΔI), der Schritt (E25) des Auswählens eines der Stromstärke-Schwellenwerte (S), der Schritt (E26) des Vergleichens des bestimmten Stromstärkeabstands (AI) mit dem ausgewählten Stromstärke-Schwellenwert (S) und der Schritt (E27) des Bestimmens des Vorhandenseins oder Fehlens eines Hindernisses eines Bahnendes während eines Abschnitts am Beginn der Bahn der Verlagerung der Abschirmung (2) beim Aufwickeln der Abschirmung (2) oder beim Abwickeln der Abschirmung (2) nach dem Erreichen eines Bahnendes ausgeführt werden.

11. Motorisierte Antriebsvorrichtung (5) einer Schließ- oder Sonnenschutzanlage für die Gebäudeautomatisierung, **dadurch gekennzeichnet, dass** die elektronische Steuereinheit (15) konfiguriert ist, das Steuerverfahren nach einem der Ansprüche 1 bis 10 auszuführen.

12. Motorisierte Antriebsvorrichtung (5) einer Schließ- oder Sonnenschutzanlage für die Gebäudeautomatisierung nach Anspruch 11, **dadurch gekennzeichnet, dass** der Elektromotor (16) des elektromechanischen Aktors vom bürstenlosen Typ mit elektronischer Kommutation ist.

## Claims

1. An operating control method of a motorized driving device (5) of a closure or sun protection home automation installation,
the closure or sun protection home automation installation comprising a concealing device (3),
the concealing device (3) comprising at least:
- a screen (2), and
- a winding tube (4),
the motorized driving device (5) comprising at least:
- an electromechanical actuator (11) making it possible to wind and unwind the screen (2) on the winding tube (4), between a wound position and an unwound position,
the electromechanical actuator (11) comprising at least:
- an electric motor (16),
- an output shaft (20) connected to the winding tube (4) of the concealing device (3), and
- an electronic control unit (15),
the electronic control unit (15) comprising at least:
- a device (28) for measuring an intensity value (I) of an electric current passing through the electric motor (16),
- a memory (27) storing a plurality of intensity threshold values (S), and
- a device (27) for detecting obstacles and ends of travel, during winding of the screen (2) and during unwinding of the screen (2),
said method comprises at least:
- a step (E21) for measuring a first intensity value (I1) of the electric current passing through the electric motor (16) via the measuring device (28),
**characterized in that** said method comprises at least:
- a step (E24) for determining a difference in intensity (ΔI) relative to the first measured intensity value (I1), after a period of time (Δt) has elapsed beginning from the moment at which the first intensity value (I1) is measured,
- a step (E25) for selecting one of the intensity threshold values (S) based on the elapsed period of time (Δt),
- a step (E26) for comparing the determined difference in intensity (ΔI) to the selected intensity threshold value (S), and
- a step (E27) for determining the presence or absence of an obstacle or an end of travel by the detection device (27) based on the result of the comparison step (E26).

2. The operating control method of a motorized driving device (5) of a closure or sun protection home automation installation according to claim 1, **characterized in that** said method comprises:
- one or more additional steps (E22) for measuring another intensity value (I2, I3, I4, I5) passing through the electric motor (16) via the measuring device (28), following the implementation of the step (E21) for measuring the first intensity value (I1) passing through the electric motor (16),
- a step (E23) for determining an evolution of the intensity value (I) traversing the electric motor (16) through steps (E21, E22) for measuring an intensity value (I1, I2, I3, I4, I5) passing through the electric motor (16),
and **in that** said method implements a step (E24) for determining a difference in intensity (ΔI) relative to the first measured intensity value (I1) when the step (E23) for determining an evolution of the intensity value (I) passing through the electric motor (16) determines an increase in the intensity value (I) passing through the electric motor (16).

3. The operating control method of a motorized driving device (5) of a closure or sun protection home automation installation according to claim 2, **characterized in that**, in the case where, during the step (E23) for determining an evolution of the intensity value (I) passing through the electric motor (16), it is determined that the intensity value (I) traversing the electric motor (16) has decreased, the control method once again carries out the step (E21) for measuring the first intensity value (I1) passing through the electric motor (16).

4. The operating control method of a motorized driving device (5) of a closure or sun protection home automation installation according to any one of claims 1 to 3, **characterized in that**, following the step (E24) for determining a difference in intensity (ΔI) relative to the first measured intensity value (I1), the method comprises a step (E28) for determining an evolution of the difference in intensity (ΔI) relative to the first measured intensity value (I1).

5. The operating control method of a motorized driving device (5) of a closure or sun protection home automation installation according to claim 4, **characterized in that** the step (E24) for determining a difference in intensity (ΔI) relative to the first measured intensity value (I1) is implemented periodically, as long as the result of the step (E28) for determining an evolution of the difference in intensity (ΔI) corresponds to an increase in the intensity value (I) passing through the electric motor (16).

6. The operating control method of a motorized driving device (5) of a closure or sun protection home automation installation according to any one of claims 1 to 5, **characterized in that** the step (E24) for determining a difference in intensity (ΔI) relative to the first measured intensity value (I1) is implemented periodically, as long as the result of the step (E27) for determining the presence or absence of an obstacle or an end of travel is different from a detected obstacle or detected end of travel.

7. The operating control method of a motorized driving device (5) of a closure or sun protection home automation installation according to any one of claims 1 to 6, **characterized in that** the step (E24) for determining a difference in intensity (ΔI) relative to the first measured intensity value (I1) is carried out periodically during a predetermined period of time (T_{L}) beginning from the moment at which the first intensity value (I1) is measured.

8. The operating control method of a motorized driving device (5) of a closure or sun protection home automation installation according to any one of claims 1 to 7, **characterized in that** the step (E21) for measuring the first intensity value (I1) passing through the electric motor (16) is carried out after a predetermined period of time (Td) has elapsed beginning from the moment when the startup of the electric motor (16) is commanded.

9. The operating control method of a motorized driving device (5) of a closure or sun protection home automation installation according to any one of claims 1 to 8, **characterized in that** said method also comprises:
- a step (E11) for determining the rotation direction of the output shaft (20) of the electric motor (16),
- a step (E12) for determining the position of the screen (2) of the concealing device (3),
- a step (E13) for determining several portions of the movement travel of the screen (2) during the winding of the screen (2) and during the unwinding of the screen (2), and **in that** at least the steps (E24) for determining a difference in intensity (ΔI), selecting (E25) one of the intensity threshold values (S), comparing (E26) the determined difference in intensity (ΔI) to the selected intensity threshold value (S) and determining (E27) the presence or absence of an obstacle or an end of travel are carried out during at least one portion of the movement travel of the screen (2), during the winding of the screen (2) or during the unwinding of the screen (2).

10. The operating control method of a motorized driving device (5) of a closure or sun protection home automation installation according to claim 9, **characterized in that** at least said steps (E24) for determining a difference in intensity (AI), selecting (E25) one of the intensity threshold values (S), comparing (E26) the determined difference in intensity (ΔI) to the selected intensity threshold value (S) and determining (E27) the presence or absence of an obstacle or an end of travel are carried out during a startup portion of the movement travel of the screen (2), during the winding of the screen (2) or during the unwinding of the screen (2), after reaching an end of travel.

11. A motorized driving device (5) of a closure or sun protection home automation installation, **characterized in that** the electronic control unit (15) is configured to carry out the control method according to any one of claims 1 to 10.

12. The motorized driving device (5) of a closure or sun protection home automation installation according to claim 11, **characterized in that** the electric motor (16) of the electromechanical actuator (11) is of the brushless type with electronic switching.
